# EUROPEAN PATENT APPLICATION

(11) **EP 3 640 995 A1**
(43) Date of publication of application: **22.04.2020**
(21) Application number: 18200443.2
(22) Date of filing: 15.10.2018
(51) Int. Cl.: H01L 29/739, H01L 29/20, H01L 29/24, H01L 29/267, H01L 21/02, H01L 21/33

(54) **A METHOD FOR FORMING A TMD - III-V HETEROSTRUCTURE AND A TFET DEVICE**

(71) Applicant: IMEC vzw, 3001 Leuven (BE)
(72) Inventor: MERCKLING, Clement, 3001 Leuven (BE); EL KAZZI, Salim, 3001 Leuven (BE)
(74) Representative: AWA Sweden AB

(57) **Abstract**

According to an aspect of the present inventive concept there is provided a method for forming a Transition Metal Dichalcogenide, TMD,- III-V semiconductor heterostructure, the method comprising: forming an insulating layer on an upper surface of a substrate, wherein the upper surface of the substrate is formed by a (111)-surface of a group IV semiconductor, forming a first aperture in the insulating layer, the aperture exposing a portion of the upper surface of the substrate, forming in a first epitaxial growth process, a semiconductor structure formed by a group III-V semiconductor comprising a pillar extending through the first aperture and a micro disc extending horizontally along a first portion of the upper surface of the insulating layer, and forming in a second epitaxial growth process, a TMD layer on an upper surface of the micro disc.

## Description

### Technical field

The present inventive concept relates to a method for forming a Transition Metal Dichalcogenide (TMD) - III-V semiconductor heterostructure on a group IV semiconductor substrate. The present inventive concept further relates to a method for forming a Tunnel Field Effect Transistor.

### Background

TMD materials are promising emerging materials due to their distinct electronics and physics properties. TMD materials may be formed with atomic monolayer thickness, so-called two dimensional (2D) structures, and with high quality.

Combination of 2D TMD materials with other semiconductor materials may be used as building blocks for formation of next generation of electronic devices such as Tunnel Field Effect Transistors (TFET) with improved properties. In particular, integration of 2D TMD materials with the well-established Si technology may have a great promise for realization of such improved next generation of electronic devices.

### Summary

An objective of the present inventive concept is to provide a method for formation of a TMD - III-V semiconductor heterostructure on a group IV semiconductor substrate. Another objective of the present inventive concept is to provide a method for formation of an improved TFET using such semiconductor heterostructure. Further or alternative objectives may be understood from the following description.

According to a first aspect of the present inventive concept there is provided a method for forming a TMD - III-V semiconductor heterostructure, the method comprising forming an insulating layer on an upper surface of a substrate, wherein the upper surface of the substrate is formed by a (111)-surface of a group IV semiconductor, forming a first aperture in the insulating layer, the aperture exposing a portion of the upper surface of the substrate, forming in a first epitaxial growth process, a semiconductor structure formed by a group III-V semiconductor comprising a pillar extending through the first aperture and a micro disc extending horizontally along a first portion of the upper surface of the insulating layer, and forming in a second epitaxial growth process, a TMD layer on an upper surface of the micro disc.

Thereby, the TMD layer may be integrated with a group IV semiconductor substrate e.g. a Si (111) substrate via an epitaxial growth process on the upper surface of the III-V semiconductor micro disc formed on the Si substrate. Such integration may hence allow formation of the TMD material on desired locations of the Si substrate. Such integration may also allow fabrication of various device types using TMD - III-V semiconductor heterostructure on IV semiconductor substrates, particularly on Si substrates.

The epitaxially grown III-V micro disc formed subsequent to the pillar growth may have an improved crystalline quality compared to a direct (with no pillar) epitaxial growth of the III-V micro disc on the Si (111) substrate. The improved crystalline quality may be related to that the strain induced from possible lattice-mismatch between Si and III-V materials may at least partly be released in the pillar.

The epitaxially grown III-V layer may provide a template for the epitaxial growth of the TMD layer and may hence allow selective growth of the TMD layer through Van Der Waals epitaxial growth process. Such epitaxial growth process may hence allow formation of the TMD layer with a controlled thickness and an improved crystalline quality including an improved interface quality between the TMD layer and the upper surface of the III-V micro disc. The formation of the TMD material with a controlled thickness may hence allow formation of 2D TMD structure.

The TMD material may comprise more than one TMD material such that a stack comprising various TMD materials may be formed.

By an insulating layer is hereby meant a non-conductive layer. The insulating layer may be formed by one or more insulating materials. Examples of such materials are oxides which may e.g. be deposited on the upper surface of Si (111) substrates.

By an aperture is hereby meant an opening extending through the insulating layer and exposing a portion of the upper surface of e.g. Si (111) substrate.

By a pillar is hereby meant a structure grown inside the aperture such that a height of the pillar may be defined by the thickness of the insulating layer.

By a micro disc is hereby meant a two-dimensional structure extending horizontally along a first portion of the upper surface of the insulating layer. The micro disc may have an overall hexagonal geometry. The micro disc may have an overall triangular geometry. Any other suitable geometry is possible.

The method may further comprise prior to the second epitaxial growth process, forming a first layer on a second portion of the upper surface of the insulating layer to cover side surfaces of the III-V micro disc. Thereby the side surfaces of the III-V micro disc may be protected against an undesired deposition of the TMD material.

The first layer may be formed of a single material or may be formed of a stack of more than one material.

The method may further comprise prior to the second epitaxial growth process, passivating the upper surface of the III-V micro disc using S, Se, or Te. The use of (111)-substrate may be advantageous since it may allow formation of (111)B-terminated III-V semiconductor micro disc and passivation of (111)B-type surface using e.g. S, Se, or Te materials may promote Van Der Waals epitaxy of the TMD layer. Hence, a TMD layer with an improved crystalline quality e.g. increased grain size may be formed. Such passivation may also improve the interface of III-V micro disc and the TMD layer e.g. by reducing the dangling bonds and interface states. In case of using the heterostructure stack to fabricate a device, performance of such device may also be enhanced by performing such a passivation step.

The first epitaxial growth process may be adapted such that a growth rate in a horizontal plane is greater than a growth rate in a vertical direction during a part of the epitaxial growth process in which the micro disc is grown. Thereby the lateral growth rate may be tuned with respect to the vertical growth rate by tuning the growth parameters such as the growth temperature. Hence, a lateral grown structure such as the micro disc may be achieved subsequent to a vertical grown structure such as the pillar.

The method according to the first aspect may advantageously be used for forming a tunnel field effect transistor, TFET. The method for forming a TFET may comprise: masking an upper surface of the TMD layer, forming a second aperture extending through the first layer, the second aperture exposing a side surface of the III-V micro disc, forming in a third epitaxial growth process, a laterally extended portion of the micro disc in the second aperture, forming a third aperture extending through the first layer, the third aperture exposing another side surface of the micro disc, recessing, from the third aperture, a portion of the III-V micro disc to form a protruding portion of the TMD from the upper surface of the III-V micro disc, forming a gate insulating layer in contact with the upper surface of the TMD, forming a gate contact on the gate insulating layer, forming a source contact in contact with the laterally extended portion of the micro disc, forming a drain contact in contact with the protruding portion of the TMD.

Thereby, the channel of the TFET may be formed in the TMD - III-V semiconductor heterostructure. The mask may be formed of more than one layer such as two layers comprising an oxide layer and a photoresist layer. The oxide layer may protect the upper surface of the TMD layer against undesired contamination. The photoresist layer may allow defining the required patterns such as the second and the third apertures through e.g. lithographic processes.

The second aperture may provide an access to a side surface of the III-V micro disc and hence allow the epitaxial growth of the lateral extended portion of the micro disc from that side. This may hence allow a source contact to be formed only in contact with the lateral extended portion of the micro disc.

The third aperture may also provide an access to another side surface of the micro disc and hence allow forming a recess and a protruding portion of the TMD layer from the upper surface of the III-V micro disc. This may hence allow a drain contact to be formed only in contact with the protruding portion of the TMD.

The III-V micro disc and the lateral extended portion of the micro disc may be doped with similar or different dopants to provide desired electrical properties. The doping process may be formed *in situ* preferably or through implantation processes.

The laterally extended portion of the micro disc may be epitaxially grown such that the growth rate in a horizontal plane is greater than a growth rate in a vertical direction. Thereby the laterally extended portion of the micro disc may be achieved providing a sufficient lateral surface area for being in contact with the source contact.

The laterally extended portion of the micro disc may be doped. An advantage provided by forming the extended portion of the micro disc in the third epitaxial growth process is that dopants may be introduced to tune the electrical properties of the extended portion of the micro disc e.g. conductivity which may hence improve the electrical properties of the obtained TFET.

The first layer of material may comprise a lower layer of a first material and an upper layer of a second material, wherein the second aperture is formed by forming an opening extending through the upper layer of the first layer of material, and selectively etching, from the opening, the lower layer to form a recess extending to the side surface of the III-V micro disc. The first material may be an amorphous material.

Thereby the lower layer and the upper layer of the first layer may be selected such that the lower layer may be selectively etched to form a recess extending to the side surface of the III-V micro disc. For instance, the lower layer may be formed of an amorphous Si material and the upper layer may be formed of an oxide material.

The TMD may be formed of WSe₂, WS₂, WTe₂, MoS₂, MoSe₂, MoTe₂, HfS₂, HfSe₂, HfTe₂, ZrS₂, ZrSe₂, or ZrTe₂. The TMD material may be chosen based on the III-V semiconductor material to obtain desired properties e.g. band alignment.

According to a second aspect of the present inventive concept there is provided a tunnel field effect transistor, TFET, device comprising: a substrate, wherein an upper surface of the substrate is formed by a (111)-surface group IV semiconductor material, an insulating layer arranged in contact with an upper surface of the substrate, a III-V semiconductor structure comprising a pillar extending through the insulating layer and abutting the upper surface of the substrate and a micro disc arranged in contact with an upper surface of the insulating layer, a TMD layer arranged in contact with an upper surface of a first portion of the III-V semiconductor micro disc, a gate oxide layer arranged in contact with an upper surface of a first portion of the TMD layer, a gate contact arranged in contact with an upper surface of the gate oxide layer, a source contact arranged in contact with an upper surface of a second portion of the III-V micro disc, wherein the second portion of the III-V micro disc is doped, a drain contact arranged in contact with an upper surface of a second portion of the TMD layer.

Thereby TMD materials may selectively be formed on desired locations of e.g. Si (111) substrates through III-V structures to form TFET devices. In addition, combination of the TMD and III-V materials may allow formation of improved TFET devices since e.g. combination of a TMD material with a III-V material may provide a desired band gap alignment. The III-V structures and the TMD layers may be epitaxially grown. The epitaxial growth processes may hence allow formation of an improved TFET device by providing a better control on the formation properties of such layers such as an improved interface between the III-V and TMD layers e.g. by using a passivation layer in between. The first and the second portions of the III-V micro disc may be doped in with similar or different dopants which may also provide an improved TFET device. The doping process may be formed *in situ* or through implantation processes.

The TMD may be formed of WSe₂, WS₂, WTe₂, MoS₂, MoSe₂, MoTe₂, HfS₂, HfSe₂, HfTe₂, ZrS₂, ZrSe₂, or ZrTe₂. The TMD material may be chosen based on the III-V semiconductor material to obtain desired TFET properties e.g. broken bandgap. For instance, in case of InAs III-V semiconductor material, WSe₂ may be used.

The second aspect may generally have the same features and advantages as the first aspect.

### Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.

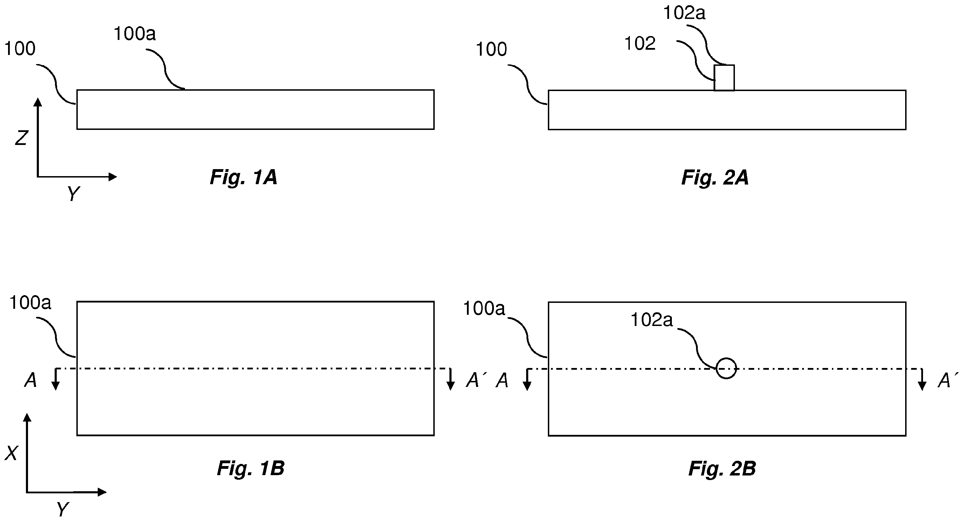

Figures 1-11 schematically illustrate a method for forming a TMD - III-V semiconductor heterostructure. Figures 1-28 schematically illustrate a method for a TFET device.

### Detailed description

A method for forming a TMD - III-V heterostructure and a TFET device including such heterostructure will now be disclosed in connection with figures 1-28. Each one of the figures shows a cross-sectional side view (figure a) of the structure and a top down view (figure b). The cross-sectional view in figure A is taken along the geometrical line indicated in the correspondingly numbered figure B (i.e. line AA'). In the figures the axis Z denotes a vertical direction, corresponding to a normal direction with respect to an upper surface 100a of a substrate 100. The axes X and Y refer to mutually orthogonal first and second horizontal directions, i.e. directions being parallel to the main plane of extension of the substrate 100 (or correspondingly the upper surface 100a thereof). It should be noted that the relative dimensions of the shown elements, such as the relative thickness of the layers of structures, is merely schematic and may, for the purpose of illustrational clarity, differ from a physical structure.

Figures 1A, 1B illustrate a semiconductor substrate 100. The semiconductor substrate 100 may be single material substrate or be formed of a combination of different materials, such as of various layers stacked on top of each other. In any case at least an upper surface 100a of the substrate 100 is formed of an elemental group IV semiconductor or compound group IV semiconductor. The upper surface may be formed by a [111] face of silicon (Si). Possible substrate 100 structures include a Si substrate or a silicon-on-insulator (SOI) substrate. The upper surface 100a of the substrate 100 may be referred to as a front side surface of the substrate 100.

In figures 2A, 2B a pillar 102 has been formed on the upper surface 100a of the substrate 100. The pillar 102 may be formed by masking a portion of the upper surface 100a of the substrate 100 and etching a portion of an unmasked portion of the substrate 100. The etching process may be formed by wet etching or dry etching.

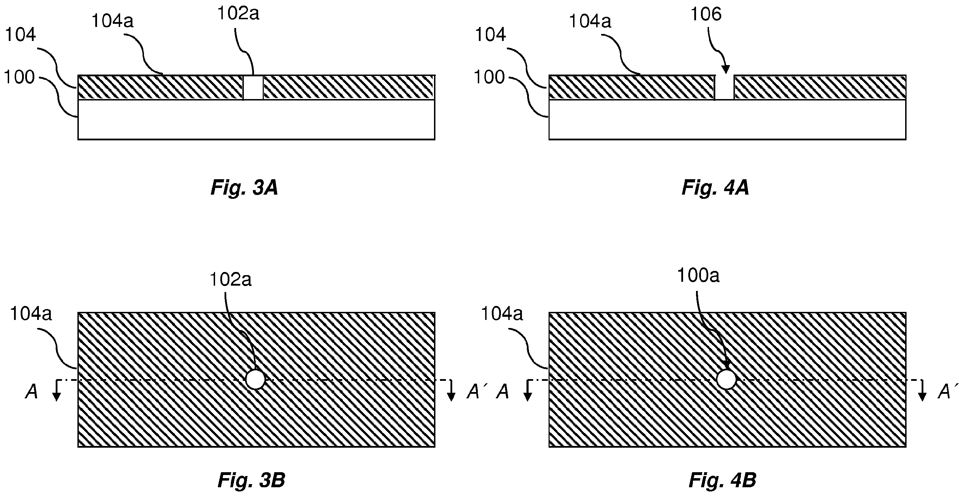

In figures 3A, 3B an insulating layer 104 has been formed on the upper surface 100a of the substrate 100. The insulating layer 104 covers the upper surface 100a. The insulating layer 102 may be an oxide layer such as SiO₂. The insulating layer 104 may also be a dielectric layer of for instance a high-K dielectric material such as aluminum oxide or some other CMOS compatible gate dielectric. The insulating layer 104 may be deposited on the surface 100a by any suitable and conventional deposition technique, such as chemical vapor deposition (CVD) or atomic layer deposition (ALD), or by thermal oxidation. The insulating layer may be etched back to expose an upper surface 102a of the pillar 102. The etching process may be performed by wet or dry etching processes such as plasma etching. The etching may also be performed by chemical mechanical polishing of the upper surface of the insulating layer 104.

In figures 4A, 4B the pillar 102 has been etched forming a first aperture 106 in the insulating layer 104. As indicated in figures 4A, 4B a bottom surface of the first aperture 106 exposes the upper surface 100a of the substrate 100. The first aperture has been formed by e.g. using the insulating layer 104 as a mask. Any conventional wet or dry etching process allowing etching of the Si pillar 102 may be employed such as tetramethylammonium hydroxide (TMAH) etching. The first aperture 106 may by way of example be formed with a dimension in the range of 20-100 nm.

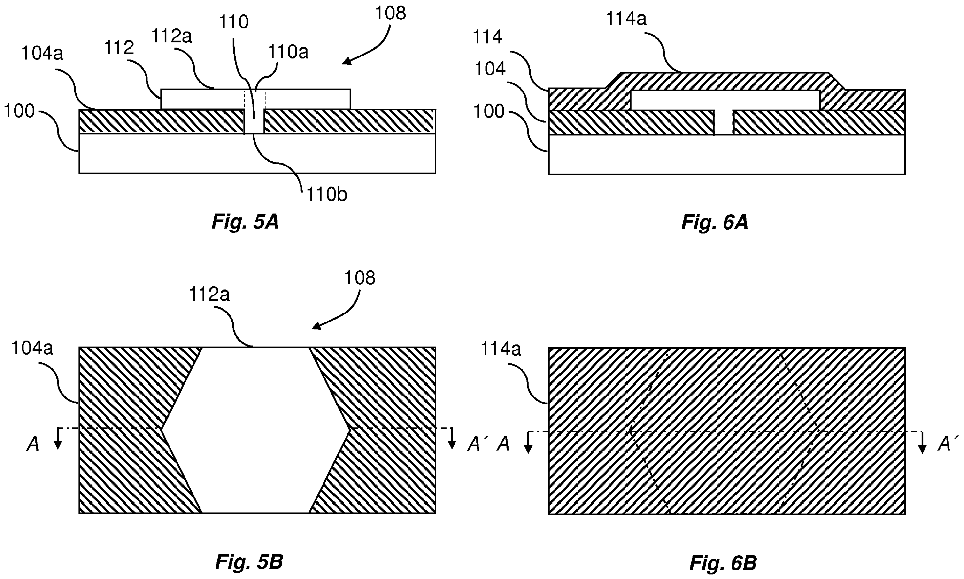

In figures 5A, 5B, a semiconductor structure 108 has been formed in an epitaxial growth process to include a group III-V semiconductor pillar 110 and a group III-V semiconductor micro disc 112. The pillar 110 is formed in the first aperture 106. The micro disc 112 is formed above the insulating layer 104. The pillar 110 has a bottom portion 110b abutting (i.e. in contact with) the upper surface of the substrate 100a. The pillar 110 may an upper portion 110a protruding from the first aperture 106 above an upper surface 104a of the insulating layer 104. The micro disc part 112 extends from the upper portion 110a of the pillar 110, horizontally or laterally along the upper surface 104a (i.e. in the horizontal plane defined by the axes X and Y). The micro disc 112 is accordingly formed to enclose the upper portion 110a of the pillar 110 in a horizontal plane, or in other words enclose in a circumferential direction with respect to the pillar 110. The semiconductor structure 108 may be formed by vapor phase epitaxy.

It should be noted that the particular polygonal shape of the disc part 112 illustrated in figure 5b merely is one example and that other shapes, such as generally hexagonal shape, also are possible. The specific shape typically may depend on the growth conditions and the orientation of the growth surfaces.

A semiconductor structure 108 may be formed of any one of InSb, GaAs, GaSb, InAs, InGaAs or InGaSb. The process conditions of the epitaxial process may be controlled such that the at least the micro disc 112 is formed of monocrystalline material, for instance monocrystalline InSb, GaAs, GaSb, InAs, InGaAs or InGaSb.

The epitaxial growth process may be adapted such that, for the group III-V semiconductor micro disc 112, a growth rate in a horizontal plane (i.e. along the first and second horizontal directions X and Y) is greater than a growth rate in a vertical direction Z. The lateral/horizontal growth rate may for instance be (at least) a factor 10 greater than the vertical growth rate. This may be implemented during at least a part of the epitaxial growth process in which the micro disc 112 is grown. However, as the lateral growth inside the first aperture 106 will be limited by the lateral dimensions of the first aperture 106 a lateral growth may be promoted throughout the epitaxial growth of the full semiconductor structure 108.

For instance, a lateral growth of a group III-V semiconductor material may be obtained by controlling a growth temperature to be in the range of 500 °C to 650 °C. A total pressure (in the growth chamber) may be in the range of 20 mbar to 150 mbar. The process conditions during the growth may be controlled such that a lateral growth rate in the range of 1 nm/s to 5 nm/s, and a vertical growth rate in or below the range 0.1 nm/s to 0.5 nm/s is obtained. The upper surface 112a of the epitaxial grown micro disc 112 may be terminated with the group V material forming a (111)B-terminated surface. The micro disc 112 may be doped either *in situ* or via an implantation process.

In figures 6A, 6B, a first material 114 has been deposited on the upper surface of the micro disc 112a and the remaining upper surface of the insulating layer 104a not covered by the micro disc 112. The first material 114 may be conformally deposited such that it covers the entire upper surface of the insulating layer 104a and the micro disc 112a as well as all the side surfaces of the micro disc 112. The first material 114 may be deposited by e.g. a chemical vapor deposition. The first material 114 may be formed of amorphous Si (a-Si).

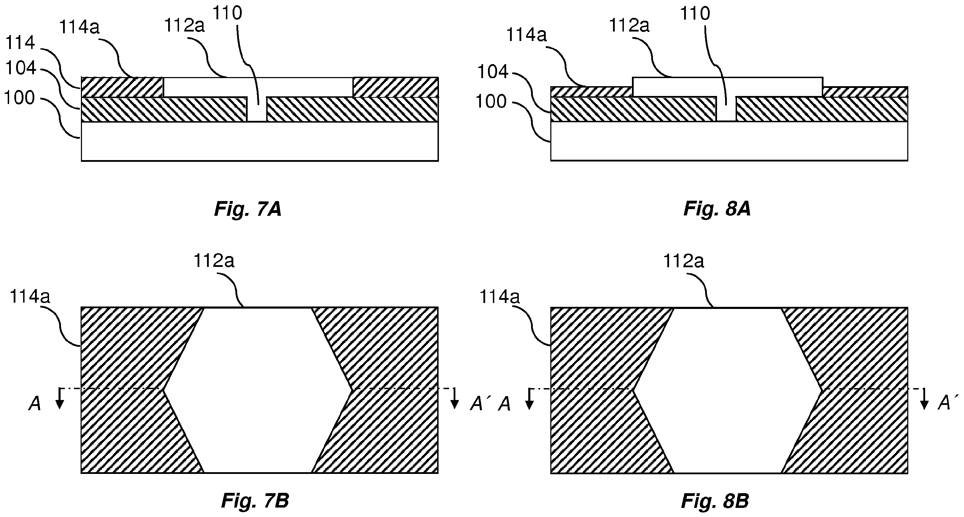

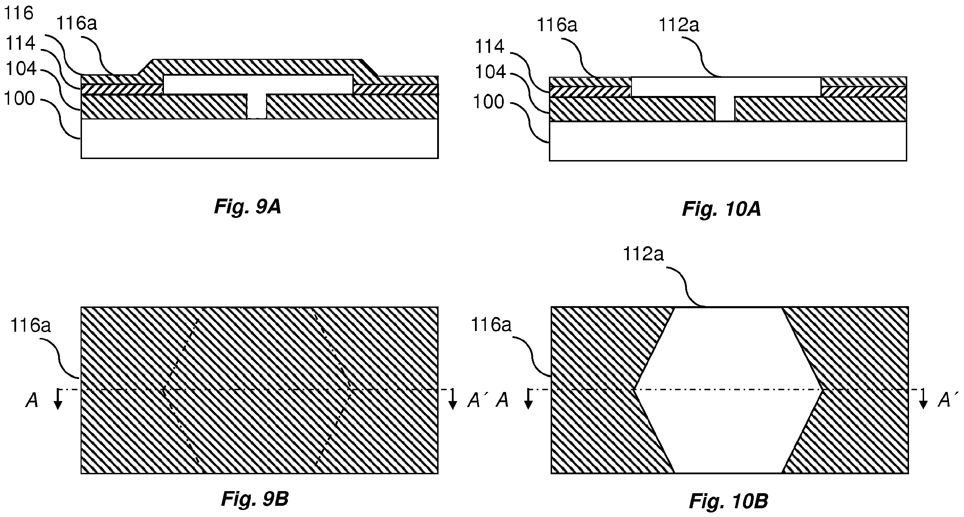

In figures 7A, 7B, a top portion of the first material 114 has been removed exposing the upper surface 112a of the micro disc 112. Hence, the first material 114 covers the side surfaces of the micro disc 112. The removal of the first material 114 may be performed using e.g. a Chemical Mechanical Polishing (CMP) step. The polishing may be controlled such that the first material 114 removal is stopped when exposing the upper surface of the micro disc 112a. Subsequently, a further top portion of the first material 114 may be additionally removed by further recessing, as shown in figures 8A and 8B. Such recessing may hence provide an access to only side surfaces of the micro disc 112. In figures 9A, 9B, a second material 116 has been deposited on the upper surface of the micro disc 112a and the upper surface 114a of the first material 114. The second material may be conformally deposited such that it covers the entire upper surface of the first material 114a and the micro disc 112a as well as all the remaining portion of the side surfaces of the micro disc 112 not covered by the first material 114. The second material may be the same material as the insulating layer 104 and may be deposited in the same way. In figures 10A, 10B, a top portion of the second material 116 has been removed exposing the upper surface 112a of the micro disc 112. Hence, the second material 116 covers the remaining side surfaces of the micro disc 112 not covered by the first material 114. Selection of the first material 114 and the second material 116 may in some embodiments be such that one may be selectively etched i.e. etching the first material 114 but not the second material 116 to provide access to a side portion of the micro disc 112. The removal of the thickness portion of the second material 116 may be performed using e.g. a CMP step. The first material 114 and the second material 116 may respectively form a lower layer and an upper layer of a first layer.

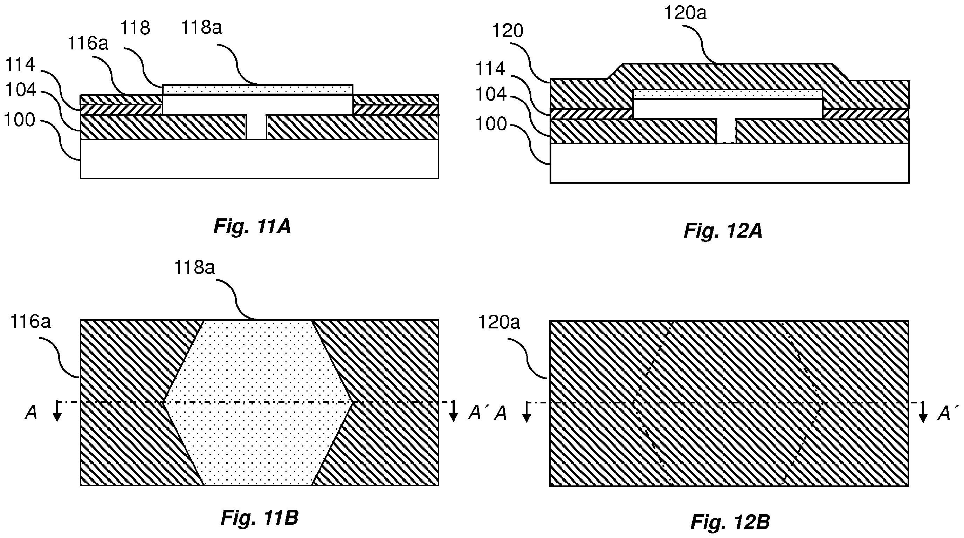

In figures 11A, 11B, a TMD layer 118 has been formed on the upper surface of the micro disc 112a. The TMD layer 118 may be epitaxially grown such that a thickness of the TMD layer 118 may be in the range from 1.2 to 12nm (1 to 10 MLs), allowing 2D growth of the TMD layer 118. The crystalline structure of the upper surface of the micro disc 112 provide a template for the epitaxial growth of the TMD layer 118 allowing the growth of the TMD materials in layer format. The epitaxial growth of the TMD layer 118 may be performed using physical or chemical vapor deposition approaches. The TMD layer may comprise one or more TMD materials for instance in a stack structure. Examples of such TMD material are MoS₂, WSe₂. Prior to the growth of the TMD layer 118, the upper surface 112a of the (111)B-terminated micro disc 112 may be passivated using e.g. S, Se, or Te. Such passivation step may be performed in the same reactor used for the TMD growth. The passivation step may for instance be performed at initial stage of the TMD growth by performing an annealing step under H₂X flow where X may be S, Se, or Te. The epitaxial growth of the TMD layer may hence be performed by changing the growth condition after the passivation step e.g. precursors and growth temperature. The epitaxial growth of the TMD layer 118 on the passivated upper surface 112a of the micro disc 112 may lead to epitaxial growth of high crystalline quality TMD layer 118 having large grain sizes. In addition, the passivation of the upper surface 112a of the micro disc 112 may reduce the dangling bonds and interface states and hence improve the heterointerface between the III-V micro disc 112 and the TMD layer 118.

Up to here, we have formed the TMD - III-V semiconductor heterostructure, defined according to claim 1. In the following, an exemplary method for forming a TFET device including such heterostructure will be disclosed in conjunction with figures 12-28.

In figures 12A, 12B, a layer 120 similar to the second material 116 has been formed on the upper surface 118a of the TMD layer 118 and the upper surface 116a of the second material 116. The layer 120 may be formed in the same way as the second material layer 116. The formation of such layer 120 may protect the TMD - III-V heterostructure during further processing steps.

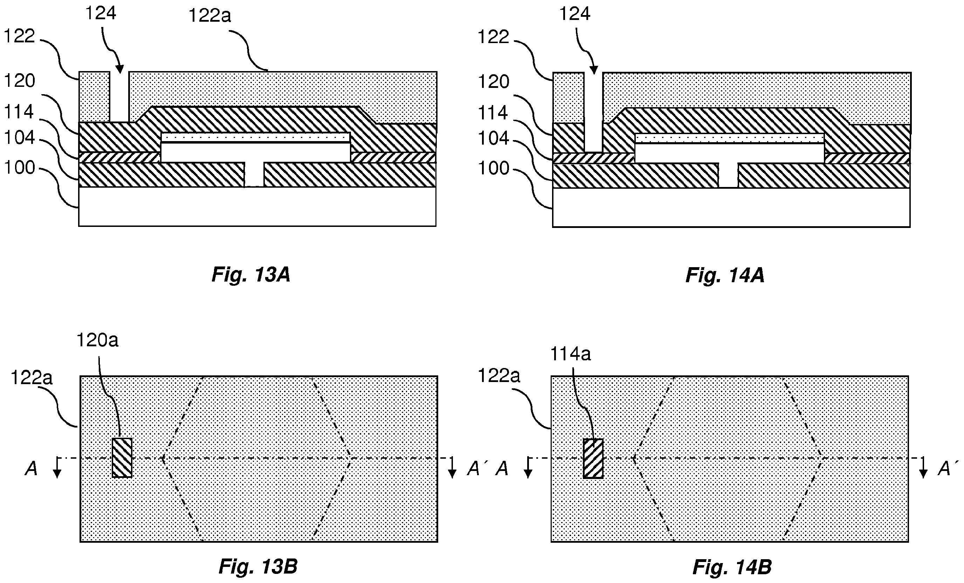

In figures 13A, 13B, a mask layer 122 has been formed on the upper surface 120a of the layer 120. The mask layer 122 may be formed by deposition of a mask material, such as a photo-resist based mask material or any other typical lithographic stack compatible material. The mask layer 122 may subsequently be defined by patterning the mask layer 122 using a conventional patterning technique to define a second aperture 124. A first portion of the second aperture 124 may be formed by removing a portion of the mask material defined through the patterning. A second portion of the second aperture 124 i.e. the portion formed of the second material 116 and 120 may subsequently be removed exposing a portion of an upper surface of the insulating layer 104, as shown in figures 14A and 14B.

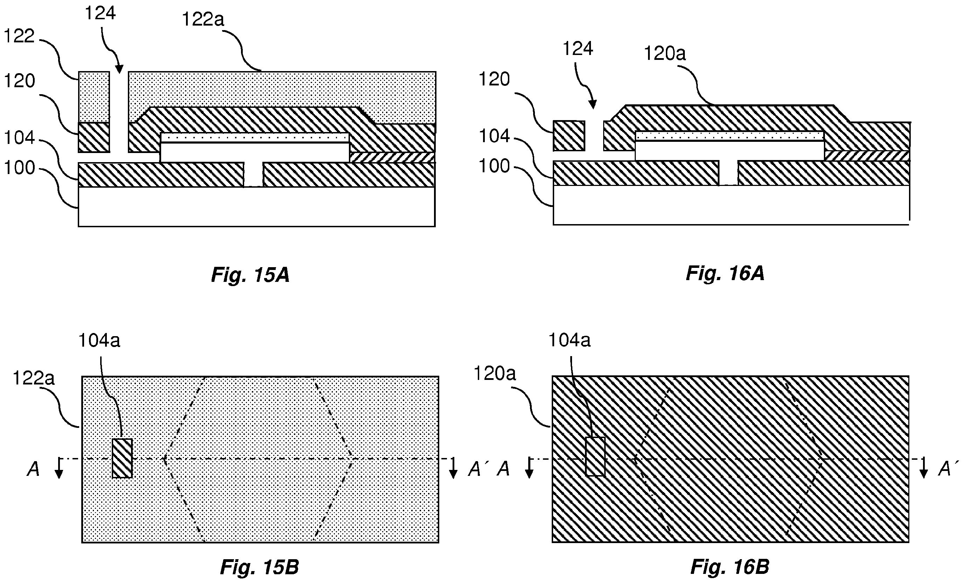

In figures 15A, 15B, a third portion of the second aperture 124 has been formed by selective etching of the first material 114 from the second portion 124b of the second aperture 124. This may hence form a recess extending to a side surface of the III-V micro disc. Afterwards, the mask layer 122 may be removed, finalizing the second aperture 124, ready for a subsequent epitaxial growth step, as shown in figures 16A and 16B. The mask layer 122 may be removed in a chemical process e.g. using a solvent to dissolve the mask material.

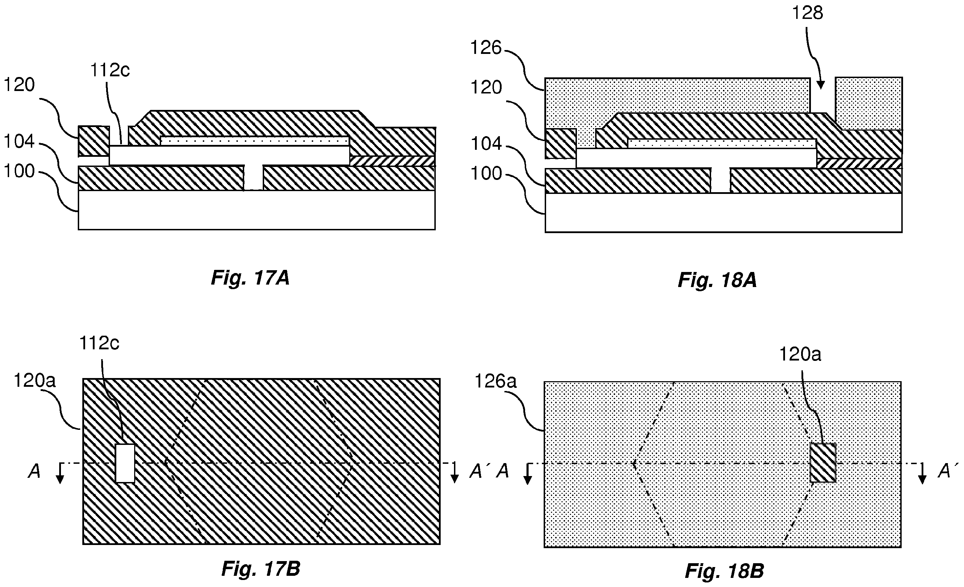

In figures 17A, 17B, a laterally extended portion 112c of the micro disc 112 has been epitaxially grown in the second aperture 124. The laterally extended portion 112c of the micro disc 112 may be grown in the same way as the micro disc 112. The laterally extended portion 112c of the micro disc 112 may have the same material composition as the micro disc 112 or may be formed of another type of III-V semiconductor material different from the micro disc 112. The laterally extended portion 112c of the micro disc 112 may be doped either *in situ* or via an implantation process. The epitaxial growth parameters used for the growth of the extended portion 112c of the micro disc 112 may be tuned similar to the growth parameters used for the micro disc 112 allowing a higher growth rate in the horizontal plane than the growth rate in the vertical direction.

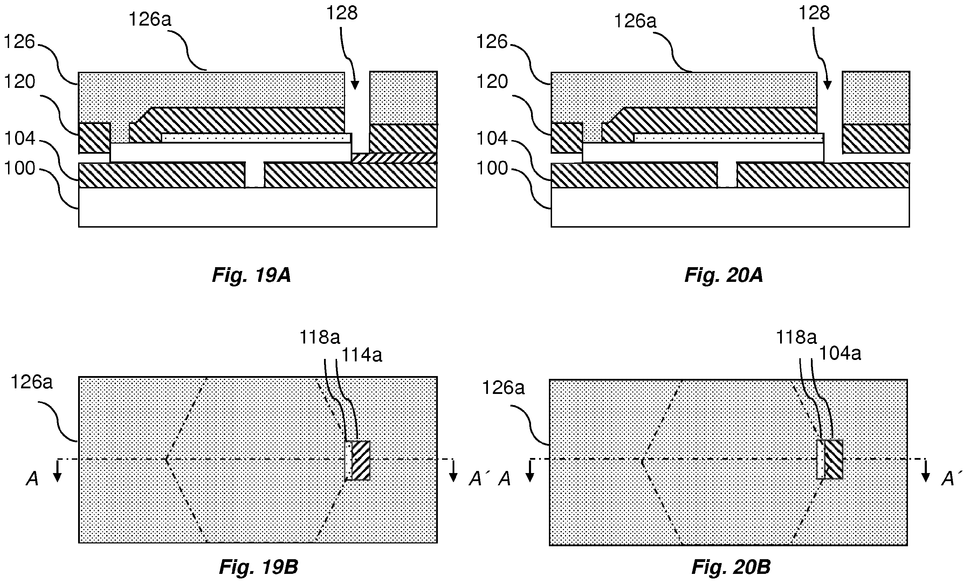

In figures 18A, 18B, another mask layer 126 has been formed on the upper surface 120a of the layer 120. The mask layer 126 may be formed in the same way as the mask layer 122. The mask layer 126 may subsequently be defined by patterning the mask layer 126 using a conventional patterning technique to define a third aperture 128. A first portion of the third aperture 128 may be formed by removing a portion of the mask material defined through the patterning. A second portion of the third aperture 128 i.e. the portion formed of the second material 116 and 120 may subsequently be removed exposing a portion of an upper surface of the TMD layer 118 and a portion of an upper surface of the first material 114, as shown in figures 19A and 19B.

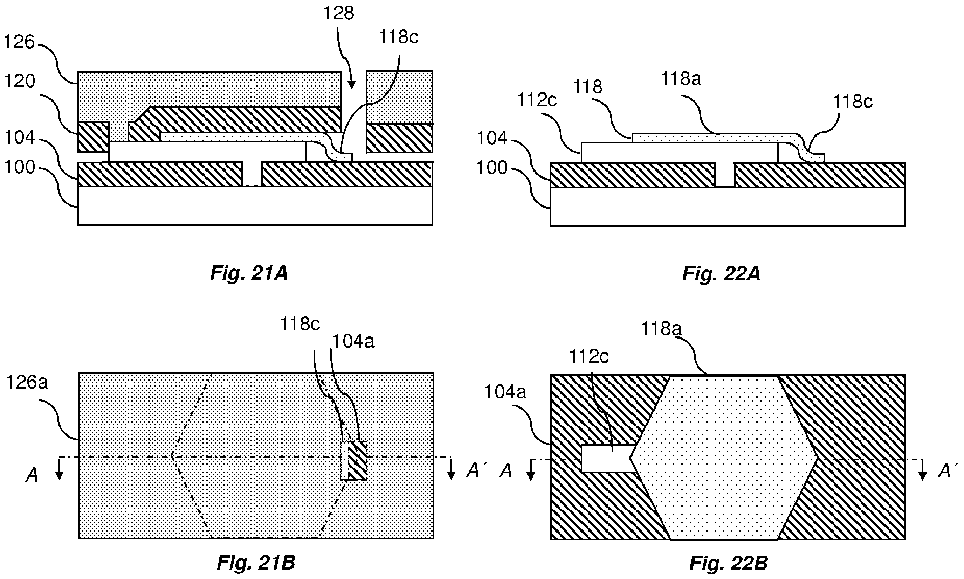

In figures 20A, 20B, a third portion of the third aperture 128 has been removed by selective etching of the first material 114 from the second portion of the third aperture 128. This may hence allow an access to another side surface of the micro disc 112. In figures 21A, 21B, a portion of the exposed side surface of the micro disc 112 has been recessed from the third aperture 128 such that a portion 118c of the TMD layer 118 may protrude from the upper surface 112a of the micro disc 112. The protrude portion 118c of the TMD layer 118 may or may not collapse on the upper surface 104a of the insulating layer 104. In the remaining figures, the protruding portion 118c of the TMD layer 118 has been exemplified in a collapsed embodiment.

The mask layer 126 and the second material layers 116 and 120 have been removed in figures 22A and 22B. The removal of the mask material for the mask layer 126 may be performed in the same way of the removal of the mask layer 122. The removal of the second material layers 116 and 120 may be performed in the same way as the etching of the insulating layer 104.

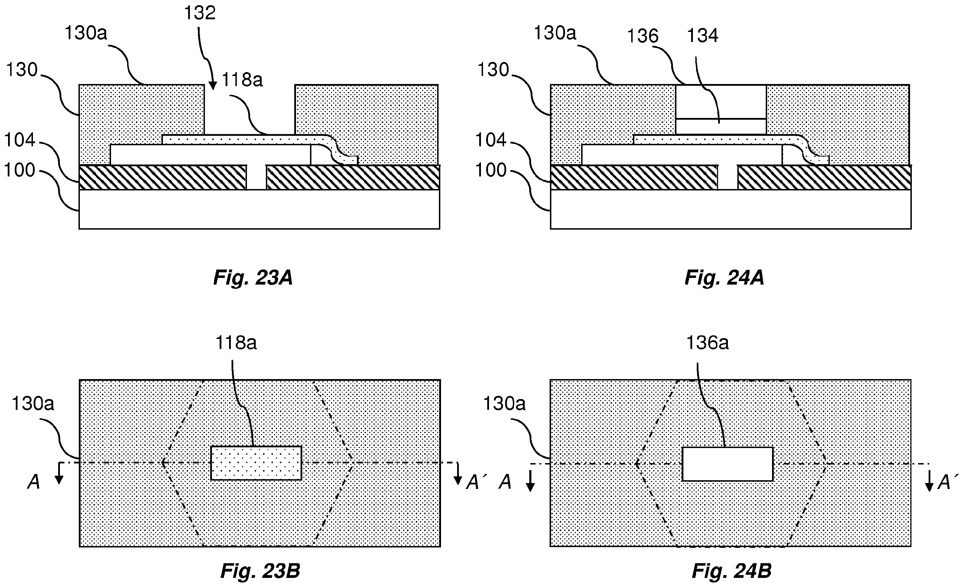

In figures 23A, 23B, a gate contact mask 130 has been formed to cover a portion of the TMD layer 118 including the protrude portion 118c of the TMD layer 118, the upper surface of the laterally extended portion 112c of the micro disc 112 and the upper surface of the remained portion of insulating layer 104 not covered by the heterostructure. The gate contact mask 130 may for instance be a resist-based mask or a PMMA mask. A gate contact opening 132 has been defined in the mask 130, exposing a portion of the upper surface 118a of the TMD layer 118. The mask opening 132 may have a rectangular top view as shown in figure 23B. The mask opening may have another top views such as square or circular shape.

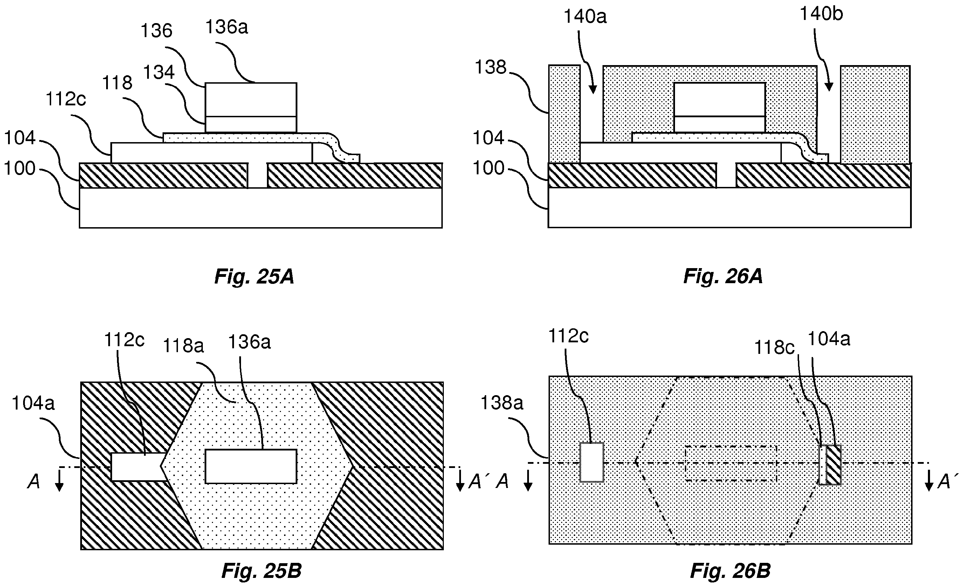

In figures 24A, 24B, a gate insulating layer 134 has been formed in contact with the upper surface of the TMD layer 118 inside the mask opening 132. The gate insulating layer 134 may be formed of a high-K dielectric material such as hafnium oxide or some other CMOS compatible gate dielectric. The gate insulating layer 134 may be deposited by any suitable and conventional deposition technique, such as chemical vapor deposition (CVD) or atomic layer deposition (ALD). A thickness of such gate insulating layer 134 may be in a range from 1 to 10 nm such that the thickness of the gate insulating layer 134 may not fill the mask opening 132. Afterwards, a gate contact layer 136 may be formed in contact with an upper surface of the gate insulating layer 134. The gate contact layer 136 may be a metal or a metal alloy. The gate contact layer 136 may be deposited by any conventional deposition technique, such as by ALD, CVD or physical vapor deposition (PVD). The material may be deposited to fill the mask opening 132. In figures 25A, 25B, the gate contact mask 130 has been removed. The removal of such mask may be performed in the same way as the way of the removal of the mask layers 122 and 126.

In figures 26A, 26B, a source/drain contact mask 138 has been formed to cover an entire upper surface of the structure except two areas: a portion of the upper surface of the laterally extended portion 112c of the micro disc 112 and a portion of an upper surface of the protrude portion 118c of the TMD layer 118. Respective mask openings 140a and 140b have been formed exposing such two areas for forming a source and a drain contact. The mask may be formed in the same way as the gate contact mask 130 and may have similar or different geometries.

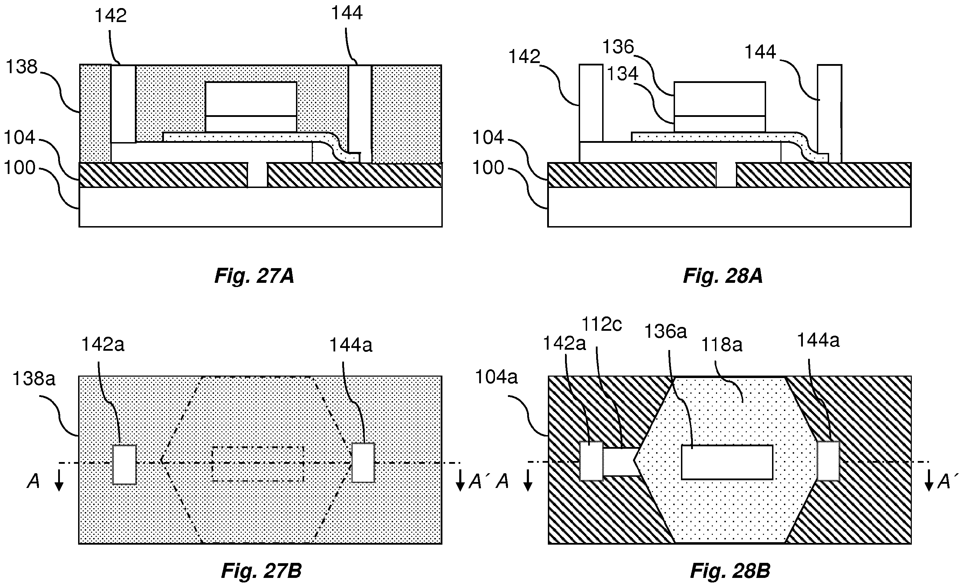

In figures 27A, 27B, a source contact layer 142 and a drain contact layer 144 have been formed. The source contact layer 142 and the drain contact layer 144 may be formed in the same way as the gate contact layer 136 and may be formed of a similar or different materials. The source contact layer 142 and the drain contact layer 144 may be deposited to fill the respective mask openings 140a and 140b.

In figures 28A, 28B, the source/drain contact mask 138 has been removed illustrating schematic illustrations of a fabricated TFET with a channel forming in the heterostructure. Figures 28A and 28B show only one example of such TFET device. The TFET device may be designed with a different layout for instance by patterning the micro disc 112 into a nanowire. The nanowire geometry allows to use a substrate surface area more efficiently when desired, since a plurality of the TMD - III-V heterostructures with the nanowire geometry may be packed on the same substrate surface area, compared to the micro disc geometry.

Further embodiments of the present disclosure will become apparent to a person skilled in the art after studying the description above. Even though the present description and drawings disclose embodiments and examples, the disclosure is not restricted to these specific examples. Numerous modifications and variations can be made without departing from the scope of the present disclosure, which is defined by the accompanying claims. Any reference signs appearing in the claims are not to be understood as limiting their scope.

## Claims

1. A method for forming a Transition Metal Dichalcogenide, TMD,- III-V semiconductor heterostructure, the method comprising:
forming an insulating layer (104) on an upper surface (100a) of a substrate (100), wherein the upper surface (100a) of the substrate (100) is formed by a (111)-surface of a group IV semiconductor,
forming a first aperture (106) in the insulating layer (104), the aperture (106) exposing a portion of the upper surface of the substrate,
forming in a first epitaxial growth process, a semiconductor structure (108) formed by a group III-V semiconductor comprising a pillar (110) extending through the first aperture (106) and a micro disc (112) extending horizontally along a first portion of the upper surface of the insulating layer (104), and
forming in a second epitaxial growth process, a TMD layer (118) on an upper surface (112a) of the micro disc (112).

2. A method according to claim 1, further comprising prior to the second epitaxial growth process:
forming a first layer (104, 114) on a second portion of the upper surface of the insulating layer (104) to cover side surfaces of the III-V micro disc (112).

3. A method according to any of the preceding claims, further comprising prior to the second epitaxial growth process:
passivating the upper surface (112a) of the III-V micro disc (112) using S, Se, or Te.

4. A method according to any of the preceding claims, wherein the first epitaxial growth process is adapted such that a growth rate in a horizontal plane is greater than a growth rate in a vertical direction during a part of the epitaxial growth process in which the micro disc (112) is grown.

5. A method according to any of the preceding claims for forming a tunnel field effect transistor, TFET, the method further comprising:
masking (116, 120, 122) an upper surface (118a) of the TMD layer (118),
forming a second aperture (124) extending through the first layer (120, 116, 114), the second aperture (124) exposing a side surface of the III-V micro disc (112),
forming in a third epitaxial growth process, a laterally extended portion (112c) of the micro disc (112) in the second aperture (124),
forming a third aperture (128) extending through the first layer(120, 116, 114), the third aperture exposing another side surface of the micro disc (112),
recessing, from the third aperture (128), a portion of the III-V micro disc (112) to form a protruding portion (118c) of the TMD (118) from the upper surface (112a) of the III-V micro disc (112),
forming a gate insulating layer (134) in contact with the upper surface (118a) of the TMD (118),
forming a gate contact (136) on the gate insulating layer (134),
forming a source contact (142) in contact with the laterally extended portion (112c) of the micro disc (112),
forming a drain contact (144) in contact with the protruding portion (118c) of the TMD (118).

6. A method for forming a TFET according to claim 5, wherein the laterally extended portion (112c) of the micro disc (112) is epitaxially grown such that the growth rate in a horizontal plane is greater than a growth rate in a vertical direction.

7. A method for forming a TFET according to claims 5 and 6, wherein the laterally extended portion (112c) of the micro disc (112) is doped.

8. A method according to any one of claims 5-7, wherein the first layer of material comprises a lower layer of a first material (114) and an upper layer of a second material (116), wherein the second aperture (124) is formed by forming an opening extending through the upper layer of the first layer of material, and selectively etching, from the opening, the lower layer to form a recess extending to the side surface of the III-V micro disc (112).

9. A method according to claim 8, wherein the first material is an amorphous material.

10. A method according to any of the preceding claims, wherein the TMD layer (118) is formed of WSe₂, WS₂, WTe₂, MoS₂, MoSe₂, MoTe₂, HfS₂, HfSe₂, HfTe₂, ZrS₂, ZrSe₂, or ZrTe₂.

11. A tunnel field effect transistor, TFET, device comprising:
a substrate (100), wherein an upper surface (100a) of the substrate (100) is formed by a (111)-surface group IV semiconductor material,
an insulating layer (104)arranged in contact with an upper surface (100a) of the substrate (100),
a III-V semiconductor structure (108) comprising a pillar (110) extending through the insulating layer (104) and abutting the upper surface (100a) of the substrate (100) and a micro disc (112) arranged in contact with an upper surface (104a) of the insulating layer (104),
a TMD layer (118) arranged in contact with an upper surface (112a) of a first portion of the III-V semiconductor micro disc (112),
a gate oxide layer (134) arranged in contact with an upper surface (118a) of a first portion of the TMD layer (118),
a gate contact (136) arranged in contact with an upper surface (134a) of the gate oxide layer (134),
a source contact (142) arranged in contact with an upper surface (112a) of a second portion of the III-V micro disc (112), wherein the second portion of the III-V micro disc (112) is doped,
a drain contact (144) arranged in contact with an upper surface (118a) of a second portion of the TMD layer (118).

12. A TFET device according to claim 11, wherein the TMD layer (118) is formed of WSe₂, WS₂, WTe₂, MoS₂, MoSe₂, MoTe₂, HfS₂, HfSe₂, HfTe₂, ZrS₂, ZrSe₂, or ZrTe₂.
